Europäisches Patentamt

European Patent Office

Office européen des brevets

(19)

(11) Publication number: **0 136 203**
**B1**

(12)

# EUROPEAN PATENT SPECIFICATION

(45) Date of publication of patent specification: **14.09.88**

(51) Int. Cl.⁴: **G 01 R 31/28, H 03 K 5/14**

(21) Application number: **84401605.5**

(22) Date of filing: **01.08.84**

(54) Apparatus for dynamically controlling the timing of signals in automatic test systems.

(30) Priority: **01.08.83 US 518499**

(43) Date of publication of application:
**03.04.85 Bulletin 85/14**

(45) Publication of the grant of the patent:
**14.09.88 Bulletin 88/37**

(84) Designated Contracting States:
**DE FR GB IT NL**

(56) References cited:
**EP-A-0 091 375**
**GB-A-2 010 552**
**GB-A-2 045 561**

**1981 INTERNATIONAL TEST CONFERENCE,
27th-29th October 1981, IEEE Computer
Society, CH-1693-1/81, paper 7.5, IEEE, New
York, USA; S. SUGAMORI et al.: "Analysis and
definition of overall timing accuracy in VLSI
test system"**

(73) Proprietor: **FAIRCHILD CAMERA &
INSTRUMENT CORPORATION
464 Ellis Street
Mountain View California 94042 (US)**

(72) Inventor: **Herlein, Richard F.
4237 Haines Avenue
San Jose California 95136 (US)**
Inventor: **Davis, Jeffrey A.
3475 Granada 312 Santa Clara
California 95041 (US)**
Inventor: **Cotriss, E. James
3653 Slopeview Drive
San Jose California 95148 (US)**

(74) Representative: **Chareyron, Lucien et al
Schlumberger Limited Service Brevets c/o Giers
12, place des Etats Unis B.P. 121
F-92124 Montrouge Cédex (FR)**

(56) References cited:
**PATENTS ABSTRACTS OF JAPAN, vol. 4, no.
24(E-173), 29th February 1980, page 140E173;
& JP - A - 54 162 945 (MITSUBISHI DENKI K.K.)
25-12-1979**

EP 0 136 203 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**0 136 203**

(56) References cited:

INTERNATIONAL TEST CONFERENCE 1983
PROCEEDINGS, 18th-20th October 1983,
CH1933-1/83, paper 8.5, pages 200-209, IEEE
Computer Society, Philadelphia, USA; R.F.
HERLEIN et al.: "Optimizing the timing
architecture of a digital LSI test system"

## Description

### Background of the invention
### Field of the invention

The invention relates to automatic test equipment used to test integrated circuits. In particular, the invention is directed to an apparatus for dynamically controlling the timing of signals in such test equipment, including synchronizing or deskewing a plurality of signals to be supplied to, or received from, an integrated circuit being tested.

### Description of the prior art

With the development of increasingly complicated integrated circuits there is a corresponding increase in the demands made upon test equipment used for quality control or evaluation of the completed devices. An example of such test equipment is the automated Sentry® series of testers manufactured by Fairchild Camera & Instrument Corporation. In automatic test equipment input signals are applied to selected pins of an integrated circuit being tested (usually known as device under test), which in response produces output signals at other selected pins. The test equipment automatically senses the response of the device under test and analyzes the response signals for their compliance with quality-control standards.

In general, the automatic test equipment has the capabilities of applying a precisely controlled preprogrammed electrical signal to desired pins of the device under test and analyzing the response signals from desired pins. With recent advancements in technology, integrated circuits may have hundreds of pins. Consequently, the test equipment may have hundres of duplicate driver and comparator circuits, one or more of each being associated with each pin of the circuit being tested. The test equipment also includes timing generators for supplying timing information for the test signals to be applied to the pins, and formatting circuits for producing patterns of test signals.

Under control of the test system computer and its programs, the test equipment can perform tests on a variety of integrated circuit devices. In each test an array of stimuli signals are applied to pins of the device under test, and the array of responses analyzed. Generally, the stimuli signals travel to each pin by a different path in the system. Similarly, the response signals from the device under test follow different paths from the output pins to the circuitry where the signals are analyzed. Because of the substantial differences in propagation delay and other detrimental influences on signal timing, it is essential to precisely control the timing of signals which are desired to arrive at the device under test at precise times or in synchronization or to be received from such device. In addition it is desirable to control the timing of signals more precisely than specified than by the clock generator of the system. Timing variations which adversely impact these goals must be corrected to assure the validity of the tests performed.

Timing errors of all types, other than cross-talk, are collectively termed "skew" herein. In an early approach to deskewing signals, a number of manually adjustable potentiometers were associated with each pin for aligning the signals. The potentiometers were readjusted whenever the equipment required recalibration, often daily or more frequently. Obviously the time and labor involved render this approach extremely undesirable.

Another approach, not necessarily in the prior art, but described herein to enable better understanding of this invention, is described in copending E.P.O. Patent Application No. 83400686.8 (EP—A—91375), entitled "Programmable Deskewing of Automatic Test Equipment", and assigned to the same assignee as the present invention, provides a system which can be programmed, in conjunction with a predetermined test, to automatically deskew the stimuli and response signals. Generally, that system includes a coarse deskew unit for rough adjustment followed by a fine deskew unit for fine adjustment. The coarse deskew unit includes a plurality of logic gates and a multiplexer. The coarse delay is determined by the number of gates through which the signal is transmitted. The fine deskew unit includes a delay line tapped along its length at intermediate intervals for connection to successive inputs of a multiplexer. After being transmitted through an appropriate number of gates to generate the coarse delay, the signal is supplied to the delay line in the fine deskew unit, and the appropriate input selectively connected to the multiplexer output. In this manner a plurality of discrete delay times can be achieved by selecting the number of delay-line segments through which the signal passes.

In British patent GB 2,010,552, a clock pulse generator is described which generates pulses of desired width at specified times. An oscillator supplies pulses (A) and a delay line converts this signal pulse into a series of pulses skewed with respect to each other. Decoders control selectors to select two appropriate pulses which are then recombined by a NOR gate to provide the desired coarse pulse. The operation may be repeated using a fine apparatus. This system passes the pulses through selectors and gates which will further skew the original pulses degrading the accuracy of the timing. This apparatus is deskewing signals with an accuracy on the order of tens of nanoseconds which is much too low for recent automatic test equipments.

### Summary of the invention

The present invention provides an apparatus for delaying an electrical signal with high resolution and accurate calibration.

According to the invention, an apparatus connected between an input terminal and an output terminal for delaying an electrical signal supplied to the input terminal before supplying it to the output terminal comprising: first means for delaying signals by a selected multiple of a first nominally predetermined delay interval, the first means connected to the input terminal to receive the electrical signal and delay it by passing it through a delay line to provide a first delayed signal at a first node, is characterized by:

N delay elements where N is an integer greater than one, each element providing a second nominally predetermined delay interval which is greater than the first nominally predetermined delay interval divided by N, and wherein the N delay elements include a second delay line having a plurality of taps at intervals thereon; and

second means connected to the first node to receive the first delayed signal, connected to the output terminal, and connected to the N delay elements, the second means being operable to pass the first delayed signal through a selected series of the N delay elements to thereby further delay the first delayed signal to provide a second delayed signal to the output terminal.

Brief description of the drawings

Figure 1 is a block schematic diagram of a delay apparatus for delaying signals by a desired amount.

Figure 2 is a schematic diagram of a differential multiplexer input stage with differential transmission lines connected thereto.

Figure 3 is a block schematic diagram of a differential multiplexer.

Figure 4 is an alternate embodiment of a differential multiplexer.

Figure 5 is an alternate embodiment of the delay apparatus.

Figure 6 is a timing diagram for the apparatus of Figure 5.

Detailed description of the preferred embodiments

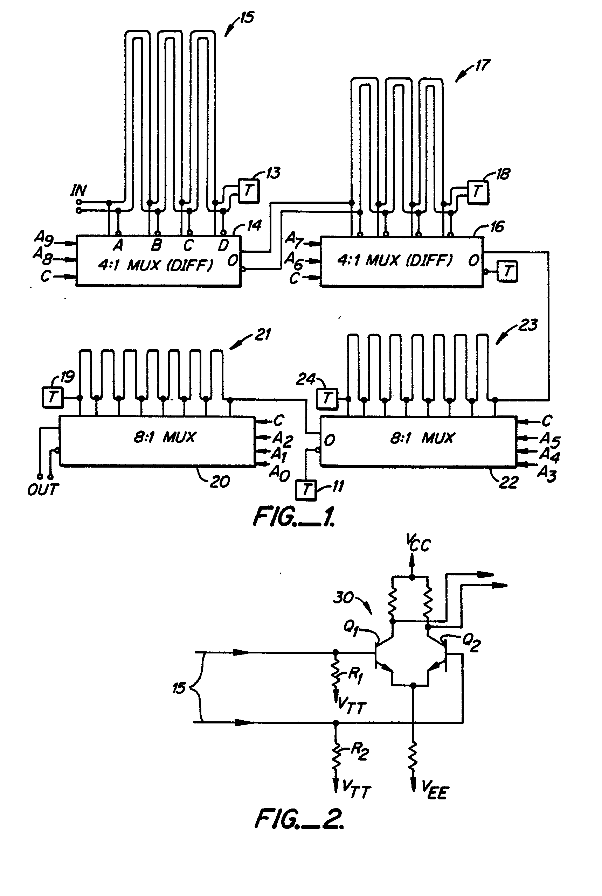

Figure 1 illustrates a four stage delay apparatus constructed in accordance with the invention. Each stage consists of a multiplexer and an associated delay line tapped at periodic intervals along its length. The taps are coupled to the input terminals of the multiplexers, and the determination of which input terminal is coupled to the output terminal of a particular multiplexer is set prior to arrival of the signal to be delayed by address signals supplied on lines $A_0$ through $A_9$. Each multiplexer receives a clock signal C which controls storage of the address signals within the multiplexer.

In the preferred embodiment the first multiplexer 14 comprises a 4:1 differential multiplexer connected to a differential transmission line 15 terminated by well known terminator 13. A second multiplexer 16, also a 4:1 differential multiplexer, is cascaded from multiplexer 14, and also coupled to transmission line 17 which is terminated by well known terminator 18. One output line O from differential multiplexer 16 is coupled to the first input terminal of 8:1 multiplexer 22. The other output line is coupled to a terminator. Multiplexer 22 includes a single-ended transmission line 23 tapped at intervals along its length and having its end coupled to terminator 24. The output signal O from multiplexer 22 is coupled, in turn, to the first input terminal of 8:1 multiplexer 20 having taps to single-ended delay line 21 coupled to its input terminals. The end of delay line 21 is coupled to terminator 19. True and complementary output terminals OUT supply the ultimate accurately delayed signals.

The circuit shown in Figure 1 operates to delay a signal supplied to it by a desired amount as follows. True and complementary input signals are supplied to nodes IN directly coupled to the first input terminal of multiplexer 14. Typically terminals IN are coupled to receive a timing signal generated under control of the test system computer. In response to the most significant address bits $A_9$ and $A_8$ previously supplied to multiplexer 14, one pair of the input terminals of multiplexer 14 will be coupled to the pair of output terminals O. As shown schematically in Figure 1, if the first pair of input terminals A is coupled to the output terminals O, the signal supplied to terminals IN will pass through the minimum amount of delay line 15, and therefore be delayed a minimum amount of time. On the other hand, if as a result of the signals on address lines $A_9$ and $A_8$, input terminals C have been coupled to output terminals O, then the signals supplied at terminals IN will pass through several loops of the delay line, and accordingly be further delayed before reaching output terminals O.

Each of the multiplexers depicted in Figure 1 operates in a manner like that described for multiplexer 14. For example, multiplexer 22 will delay the arrival of a signal at its output terminals O by an amount depending upon which input terminal of multiplexer 22 is coupled to its output terminal. Which input terminal is coupled to the output terminal is determined by the address information previously supplied on lines $A_3$, $A_4$ and $A_5$. This address information determines the length of delay line 23 through which the signals supplied to multiplexer 22 must pass before being coupled to the output terminal of that demultiplexer.

In cascaded arrangements of coarse and fine vernier stages, the coarser stage usually provided a plurality of delay intervals each of which was an integral multiple of a fundamental predetermined delay interval. The finer vernier stage would then divide the fundamental delay interval of the coarse stage into a desired number of equal-duration time intervals to provide predetermined submultiples of the fundamental delay intervals. In this manner the usual fine cascaded vernier stage having, say, seven delay elements would provide further delays of 1/8, 2/8, 3/8, etc., of the coarser preceding delay interval. Of course, if the signal passes serially through all stages the order of the stages may be changed and the fine stages placed ahead of the coarser stages.

In the present invention one or more subsequent delay stages provide fractional portions of the previous stage's fundamental delay interval which are only nominally predetermined. For example, where an 8 stage vernier systems would subdivide the previous coarser-stage fundamental delay interval into eighths, the vernier system of the present invention may provide eight segments, but each segment provides a delay greater than 1/8 of the previous-stage fundamental delay. Thus, in the embodiment of Figure 1 the segments of transmission line 23 between successive taps to multiplexer 16 each have a length which causes a delay greater than one-eighth of the individual delay interval of multiplexer 16. In the preferred embodiments in a vernier stage with divisions of "one-eighth", the delay provided by each segment is increased by about 25 percent, although the precise amount of enhancement is not critical. For a vernier stage with divisions of "one-fourth", the corresponding enhancement is also about 25 percent.

In the preferred embodiment of the system depicted in Figure 1, the true and complement signals arrive at terminals IN with a resolution on the order of 5 nanoseconds or better, and it is desired for the ultimate output signals supplied at terminal OUT to have an accuracy within on the order of 10 picoseconds. Table 1 below shows the timing steps effected by each address bit.

TABLE 1

| | | |
|---|---|---|
| $A_0$ | 10 ps | |
| $A_1$ | 20 ps | Stage 20 |
| $A_2$ | 40 ps | |
| $A_3$ | 62 ps | |
| $A_4$ | 124 ps | Stage 22 |
| $A_5$ | 248 ps | |
| $A_6$ | 400 ps | Stage 16 |
| $A_7$ | 800 ps | |
| $A_8$ | 1.25 ns | Stage 14 |
| $A_9$ | 2.5 ns | |

The fractional portions provided by the present vernier system, for example stage 22 relative to stage 16, are referred to herein as "nominally predetermined" because they are not precisely predetermined. In the first approximation they subdivide the previous-stage fundamental delay interval into equal portions, but in accordance with the invention each delay element of the vernier system is increased by a desired amount. This small enhancement allows for correction of tolerances in the process by which the individual stages are fabricated. Of course the first stage of a cascaded arrangement will be divided into any desired number of segments without compensation.

In the preferred embodiment transmission lines 15, 17, 21 and 23 are conductive regions printed or otherwise formed on a ceramic substrate, on a printed circuit board, or on other suitable substrates. These regions are connected to the terminals of the multiplexers using well known techniques.

Previously, the segments of the vernier system delay line were equal to one another within a high degree of accuracy relative to the desired resolution and had a precise predetermined length to assure the proper vernier division. This was achieved by fabricating the vernier system delay line with a plurality of shorting bars, appropriate ones of which were then burned away by a laser to provide the desired delay. In the present construction, however, no laser trimming is necessary.

In the preferred embodiment the first two delay stages include multiplexers 14, 16 and delay lines provided by differential transmission lines 15, 17. The differential transmission lines are preferably provided by a pair of substantially parallel conductive traces, usually formed into a serpentine path to conserve surface area on a substrate adjacent the location where the multiplexer chip is attached.

One advantage of employing a differential transmission line may be understood by reference to Figure 2, which shows an emitter coupled logic differential input stage 30, typically used in multiplexers 14, 16, 20, 22. The two sides of transmission line 15 are connected to the bases of transistors Q1 and Q2 across load resistors R1 and R2. In a typical single-ended arrangement the transmission line is connected only to the base of transistor Q1, and an internally generated reference voltage is applied to the base of transistor Q2. In the single-ended arrangement the signal to be delayed is thus compared with the internally generated reference voltage and the difference is amplified.

As is well known, a signal travelling along a transmission line is attenuated due to the effects of the distributed resistance of the line itself. The distributed resistance of a single-ended transmission line increases with the length of the line and also depends upon the cross-sectional profile of the line and substrate. The resistance of the line and the load resistor R1 in effect define a voltage divider. When the distributed resistance is a significant fraction of the load resistance, a false comparison with the internally generated reference voltage may result, yielding an erroneously delayed signal. This problem is overcome by the use of differential transmission lines 15 and 17. In the preferred manner of operation the signal to be delayed is applied to one side of transmission line 15, 17 and a complementary signal applied to the other. Both signals will then be subject to substantially the same attenuation, so that for lines of reasonable length, the output crossover will occur a fixed time after the input crossover and no false comparison will result.

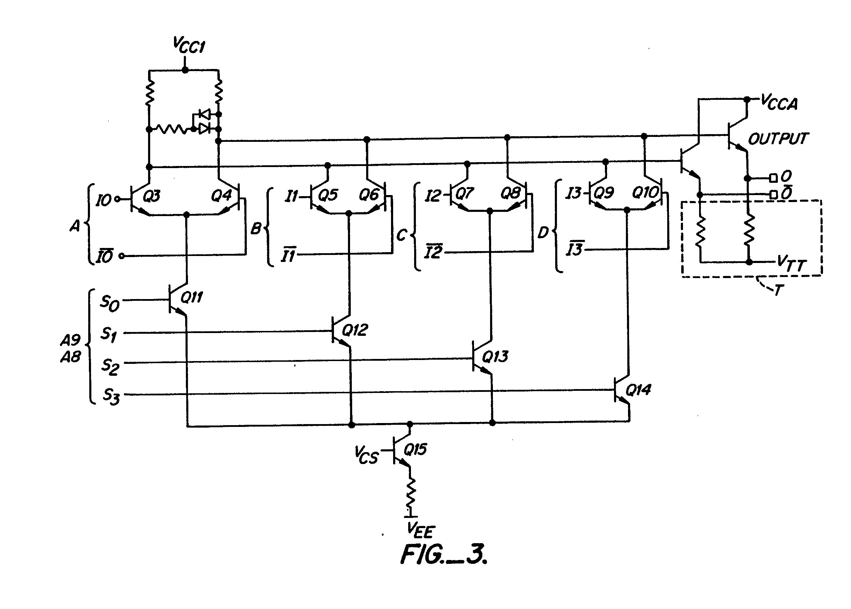

A preferred embodiment of differential multiplexers 14 and 16 are shown in Figure 3. For convenience, the circuit of Figure 3 will be described in conjunction with multiplexer 14, however, it will be understood that the circuit is equally applicable to the construction of multiplexer 16, as well as other constructions. The circuit shown in Figure 3 includes four pairs of transistors Q3—Q10, each pair having commonly coupled emitters in the manner shown. Each pair of transistors is coupled to a corresponding pair of input terminals of multiplexer 14. For example, the base of transistor Q5 is coupled to one terminal of the second pair of input terminals B of multiplexer 14, while the base of transistor Q6 is coupled to the other of pair B.

Using a well known decoder (not shown) address inputs $A_9$ and $A_8$ are decoded into four signals $S_0$, $S_1$, $S_2$, and $S_3$. For any given condition of the pair of address lines $A_9$ and $A_8$ only one of signals $S_0$ through $S_3$ will be high, and correspondingly only one of transistors Q11—Q14 will be coupled to supply $V_{EE}$ through current source transistor Q15. Accordingly, the input signal received at only one of the pairs of input terminals A, B, C and D will be coupled to the output terminals O and $\bar{O}$.

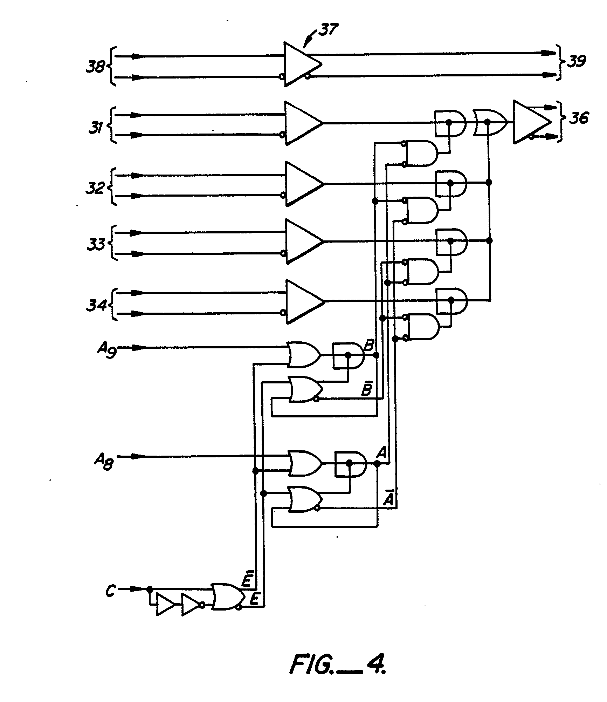

Another embodiment for addressable multiplexers 14 or 16 having differential inputs and a differential output is illustrated in Figure 4. The circuit includes differential complementary input pairs 31—34, which can be selectively connected to differential output pair 36. The addressing of inputs 31—34 by means of clocked address lines $A_9$ and $A_8$ (or $A_7$ and $A_6$) is well known. The circuit shown in Figure 4 also contains an independent buffer circuit 37 having an input pair 38 and output pair 39. In the preferred embodiment buffer circuit 37 is interposed between the IN terminals of Figure 1 and a preceding transmission-line driver circuit (not shown). Buffer circuit 37 makes the input signal independent of the external driver circuit characteristics.

The dynamically controllable timing apparatus of Figure 1 is calibrated in the following manner, which may be called a "software trim" in distrinction to the prior art laser trim. A signal and its complement, to be delayed are applied to nodes IN, and the first tap of all stages is addressed by the respective multiplexers and connected to the respective multiplexer outputs. The propagation delay of the circuit is measured and serves as a reference time. This signal will represent the minimum delay condition. Each of the multiplexers are then stepped through their various addresses so as to selectively connect the multiplexer inputs to their respective outputs in a selected number of combinations, and the resulting time delays are measured. The measured delay associated with each combination of addresses is stored in the memory of the test system computer. In this manner a discrete transfer function for the overall delay apparatus is created. The calibration of the delay apparatus will then be fixed and always readily available from the memory.

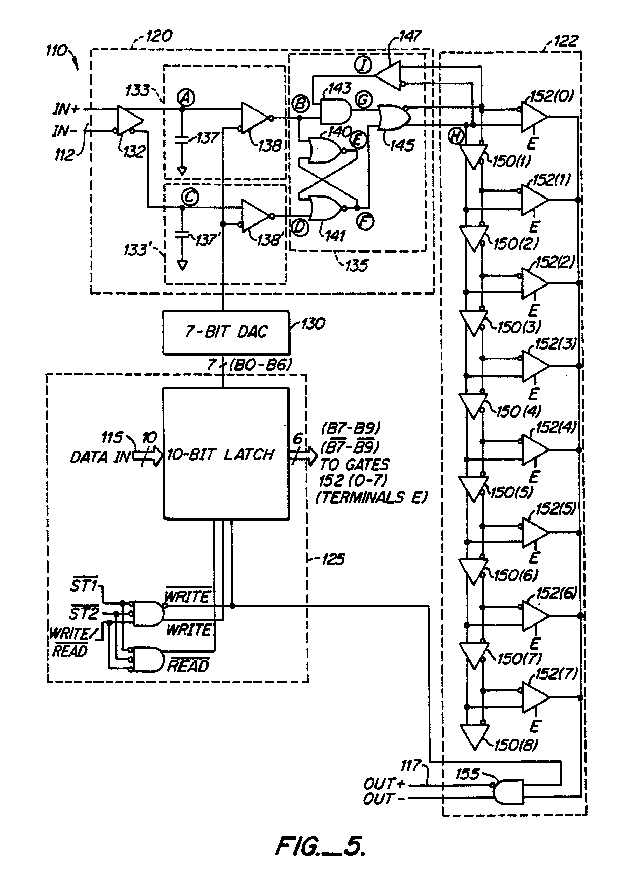

Figure 5 is a logical schematic of another embodiment of a deskew element 110 which may be incorporated into critical timing paths in automatic test equipment. In its broadest sense, the operation of deskew element 110 is to take an incoming pulse at a differential input 112, delay it by a variable amount of time according to the digital code at a multi-bit data input 115, and present the delayed signal at a differential output 117.

While particular timing parameters will be described in conjunction with the apparatus of Figure 5, it is to be understood that the present invention is not so limited. Deskew element 110 is designed to take an incoming pulse of 5-ns width at a 20-ns repetition rate, and to provide a variable increment of delay in the range of 0—5.12 ns from nominal in steps of approximately 10 ps. To this end, the deskew element has the capability of providing an overall delay of 8.2 ns, as described below.

The main components of deskew element 110 are fine delay circuitry 120, coarse delay circuitry 122, latching circuitry 125, and a 7-bit digital/analog converter ("DAC") 130. Data input 115 has ten bits, seven bits of which (B0—B6) are communicated to the inputs of DAC 130; the remaining three bits (B7—B9) are communicated (as complementary pairs) to coarse delay circuitry 122. DAC 130 produces an analog voltage of 0.25—1.25 volts corresponding to the 7-bit code at its input, and a voltage derived from this is communicated to fine delay circuitry 120. The particular construction of latching circuitry 125 and DAC 130 is not directly related to the present invention, and is well known. Furthermore, because the coarse delay circuitry 122 and fine delay circuitry 120 are cascaded, they could be coupled together in reverse order.

Fine delay circuitry 120 includes a differential receiver 132, first and second ramp generators 133 and 133', and a reconstruction (set/reset) latch 135. Broadly, fine delay circuitry 120 takes the differential input pulses and splits the leading and trailing edges into ramp generators 133 and 133' which compare those edges with a threshold derived from the DAC output voltage. Ramp generators 133 and 133' comprise respective capacitors 137 and 137' and respective comparators 138 and 138'. After the ramp voltages are sensed by comparators 138 and 138', the pulse is reconstructed by reconstruction latch 135. Edge timing in fine delay circuitry 120 is approximately 800 mv/ns, whereupon the 1-volt variation in the output voltage from DAC 130 provides up to approximately 1.25 ns of controlled fine delay variation.

Latch 135 includes cross-coupled gates 140 and 141 which receive as set and reset inputs the signals from comparators 138 and 138'. The output from comparator 138 is also communicated to a first input of a gate 143. The respective outputs of gates 141 and 143 are communicated to a latch output gate 145, the differential outputs of which communicate to a coarse delay circuitry 122 and also communicate via a feedback gate 147 to a second input of gate 143.

The pulse, as reconstructed at the output of gate 145, is communicated to coarse delay circuitry 122. Coarse delay circuitry 122 includes a delay line 150 comprising cascaded gate stages 150(1), 150(2), . . . and 150(7), the respective outputs of which also communicate the respective multiplexer output gates 152(1), 152(2), . . . and 152(7). A dummy gate 150(8) ensures that the capacitance is the same as the outputs of all the gates in delay line 150. The reconstructed pulse communicates to the input of gate 150(1), and also to a multiplexer output gate 152(0). The outputs of all output gates 152(0—7) are tied to an output buffer 155. Each gate in delay line 150 produces a 1-ns delay, for a total of up to 7 ns of coarse delay, depending on which of output gates 152(0—7) is selected by bits B7—B9 of the data inputs which are coupled to enable terminals E on each gate 152.

The preferred embodiment of the present invention is implemented in emitter coupled logic ("ECL").

In accordance with known practice, each gate stage includes a differential transistor pair having the transistors' emitters coupled to a common circuit point, and a current source coupled thereto. The transistors' collectors are resistively coupled to a supply voltage, and at least one of the transistors' collectors is coupled through an emitter follower to an output terminal. The relative current flow through the transistors (and hence the relative collector voltage) is determined by the relative voltages at the transistors' bases.

For a differential input signal, the two components are communicated to the bases; for a single-sided signal, one base receives the signal and the other base is held at a threshold voltage. The threshold voltage may be a nominally fixed reference level (as in gates 140, 141, 143, and 145) or a controlled signal reference (as in comparators 138 and 138'). The emitter follower stages through which the output signals are coupled use constant current sources for their loads.

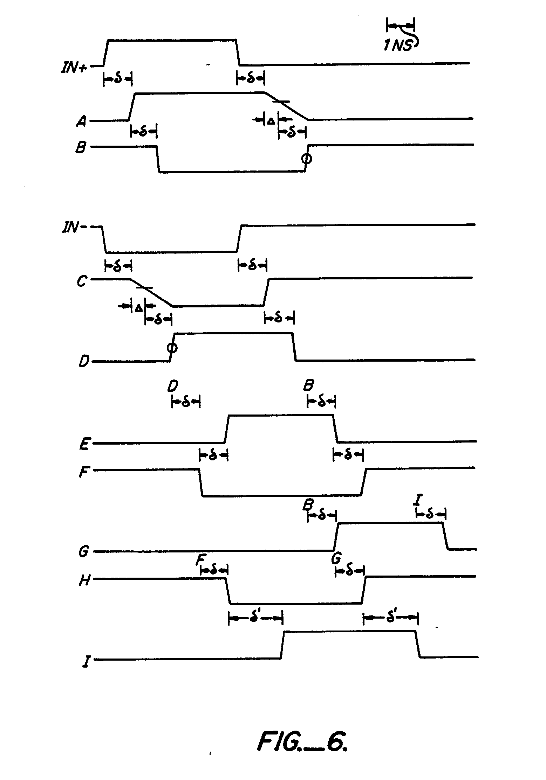

The operation of fine delay circuitry 120 may best be understood with reference to Figure 6 which is the timing diagram showing the signals at nodes A—H in the circuitry. The nodes are defined as follows:

A—input to comparator 138
B—output from comparator 138
C—input to comparator 138'
D—output from comparator 138'
E—output from gate 140
F—output from gate 141
G—output from gate 143
H—output from gate 145
I—output from gate 147

For purposes of illustration, the input signal may be assumed to be a 5-ns wide pulse having differential components IN+ and IN−. In the discussion that follows, it will be assumed that each gate except feedback gate 147 provides a fixed increment of delay, designated δ, which is approximately 1 ns. Feedback gate 147 is characterized by a longer gate delay, designated δ', which is approximately 2 ns.

The positive input signal IN+ is communicated through differential input gate 132 to node A. Since the input gate has an emitter follower, the rise in IN+ causes a rapid rise at node A, one gate delay later. However, the fall in IN+ does not result in a rapid fall at node A, but rather a more gradual fall which has a slope defined by the load current and the capacitor value. Thus, the fall at node A is linear with a fall time of approximately 1.5 ns. For purposes of illustration, it will be assumed that the voltage at node A becomes equal to the DAC voltage a time interval Δ after the voltage at A begins to fall.

Consider now the signal at node B. Comparator 138 introduces one gate delay as well as inversion. When A rises, B falls one gate delay later. B rises one gate delay after A falls to a level matching the voltage of DAC 130. The trailing (rising) edge of the signal at B is one of the two edges that is ultimately reconstructed into the delayed pulse.

Similarly, the negative input signal IN− produces a signal at node C which has a leading (falling) edge having a slope defined by the constant current source and the capacitor, and a trailing (rising) edge that rises rapidly. As above, where the voltage at C reaches the DAC voltage after an interval Δ, the rising edge at node D occurs one gate delay later, and the trailing edge occurs one gate delay after C rises. The leading (rising) edge of the signal at D is the other edge that is ultimately reconstructed.

Gates 140 and 141 define a set/reset latch whose state changes each time either B or D goes high. Thus, since it is the rising edges of the signals at B and D that are to be reconstructed, the latch has the effect of reconstructing the pulse. The signals at B and D follow different paths prior to being reconstructed at H. When D rises, F falls one gate delay later, and then H falls one more gate delay later, thereby reconstructing the leading edge of D (which corresponds to the delayed leading edge of the input signal). The signal at B follows a slightly different path prior to reaching to node H. Rather than go through the latch which would add an extra delay, a look-ahead path is utilized. The signal at B is propagated through gate 143, whereupon G rises one gate delay after B rises, and H rises one more gate delay later to reconstruct the trailing edge of B (which corresponds to the delayed trailing edge of the input signal). However, the rise in H is propagated through the feedback network (characterized by the longer gate delay) to I (one of the inputs of gate 143) which causes G to fall. Thus, when B rises, G rises, but then falls a short time later because of the feedback. However, by that time, B has risen and has reset latch 135. F rises again and reinforces G so that by the time G falls, F has risen to keep H high. In this manner, the outputs at gate 145 are delayed relative to the differential input signal by a variable amount Δ (in addition to four fixed gate delays).

In summary, it can be seen that the apparatus of the present invention can be fabricated compactly. Better resolution may be obtained, and the delay apparatus can be calibrated accurately without resorting to laser trimming or other expensive manufacturing processes. The apparatus permits dynamic control of signal timing and enables the combination of less accurate multiplexers to obtain a more accurate result.

Other embodiments of the invention could include obvious variations of the apparatus described. For example, other types of variable delay elements may be used in place of the multiplexer-delay line combinations illustrated by the preferred embodiment. Therefore, the above description and illustration should not be construed as limiting the scope of the invention, which is defined by the appended claims.

**Claims**

1. Apparatus connected between an input terminal and an output terminal for delaying an electrical signal supplied to the input terminal before supplying it to the output terminal, the apparatus comprising:

first means (14, 15; 16, 17) for delaying signals by a selected multiple of a first nominally predetermined delay interval, the first means connected to the input terminal to receive the electrical signal and delay it by passing it through a delay line to provide a first delayed signal at a first node; characterized by

N delay elements (23) where N is an integer greater than one, each element providing a second nominally predetermined delay interval which is greater than the first nominally predetermined delay interval divided by N, and wherein the N delay elements include a second delay line having a plurality of taps at intervals thereon;

second means (22) connected to the first node to receive the first delayed signal, connected to the output terminal, and connected to the N delay elements, the second means being operable to pass the first delayed signal through a selected series of the N delay elements to thereby further delay the first delayed signal to provide a second delayed signal to the output terminal.

2. Apparatus according to claim 1, characterized in that the first means (14, 15; 16, 17) comprises:

first multiplexing means (14; 16) having a plurality of input terminals; and

a first transmission line (15; 17) having a plurality of taps at intervals thereon, each tap connected to a successive input terminal of the first multiplexing means.

3. Apparatus according to claim 1 or 2, characterized in that the second means comprises:

second multiplexing means (22) having a plurality of input nodes; and

wherein the N delay elements comprise a second transmission line (23) having the plurality of taps at intervals thereon, each tap connected to a successive input node of the second multiplexing means.

4. Apparatus according to claim 2 or 3, characterized in that the first multiplexing means (14; 16) includes addressable controls for selectively connecting one of the taps on the first transmission line to the first node.

5. Apparatus according to claim 4, characterized in that the first multiplexing means (14; 16) comprises a first multiplexer (14; 16) including differential input stages, and the first transmission line (15; 17) comprises a differential transmission line connected to the differential input stages.

6. Apparatus according to claim 5, characterized in that termination means (13; 18) are provided following a last input terminal of the first multiplexer (14; 16) to terminate the first transmission line (15; 17).

7. Apparatus according to any one of claims 3—6, characterized in that the second multiplexing means (22) includes addressable controls for selectively connecting one of the taps on the second transmission line to the output terminal.

8. Apparatus according to any one of claims 1—7, characterized by:

a set of M delay elements (21), where M is an integer, each element providing a third nominally predetermined delay interval, which third nominally predetermined delay interval is greater than the second nominally predetermined delay interval divided by M; and

third means (20) connected between the output terminal and the second means to receive the second delayed signal from the second means, and connected to the M delay elements, the third means being operable to pass the second delayed signal through a selected series of the M delay elements and delay it to provide a third delayed signal to the output terminal.

9. Apparatus according to claim 8, characterized in that:

the third means comprises a third multiplexing means (20) having a plurality of input terminals and at least one third output terminal, and

the set of M delay elements comprises a third transmission line (21) having a plurality of taps at intervals connected to successive input terminals of the third multiplexer.

**Patentansprüche**

1. Zwischen eine Eingangsklemme und eine Ausgangsklemme geschaltete Anordnung für das Verzögern eines der Eingangsklemme zugeführten elektrischen Signals, bevor es der Ausgangsklemme zugeführt wird, welche Anordnung umfaßt:

Erste Mittel (14, 15; 16, 17) für das Verzögern von Signalen um ein ausgewähltes Vielfaches eines ersten nominell vorgegebenen Verzögerungsintervalls, welche ersten Mittel an die Eingangsklemme angeschlossen sind zum Empfang des elektrischen Signals und seiner Verzögerung mittels Durchspeisens desselben durch eine Verzögerungsleitung zum Erzeugen eines ersten verzögerten Signals an einem ersten Knoten,

gekennzeichnet durch

N Verzögerungselemente (23), wobei N eine ganze Zahl größer als eins ist, wobei jedes Element ein zweites nominal vorgegebenes Verzögerungsintervall liefert, das größer ist als das erste nominell vorgegebene Verzögerungsintervall, dividiert durch N, und wobei die N Verzögerungselemente eine zweite Verzögerungsleitung umfassen mit einer Mehrzahl von Anzapfungen an Intervallen derselben;

zweite Mittel (22), angeschlossen an den ersten Knoten zum Empfang des ersten verzögerten Signals, angeschlossen an die Ausgangsklemme und verbunden mit den N Verzögerungselementen, wobei die zweiten Mittel betätigbar sind zum Durchschleusen des ersten verzögerten Signals durch eine ausgewählte Serie der N Verzögerungselemente, um so das erste verzögerte Signal weiter zu verzögern zum Bereitstellen eines zweiten verzögerten Signals an der Ausgangsklemme.

2. Anordnung nach Anspruch 1, dadurch gekennzeichnet, daß die ersten Mittel (14, 15; 16, 17) umfassen:

Erste Multiplexiermittel (14, 16) mit einer Mehrzahl von Eingangsklemme und

eine erste Übertragungsleitung (15, 17) mit einer Mehrzahl von Anzapfungen an Intervallen derselben, wobei jede Anzapfung an eine aufeinanderfolgende Eingangsklemme der ersten Multiplexiermittel angeschlossen ist.

3. Anordnung nach Anspruch 1 oder 2, dadurch gekennzeichnet, daß die zweiten Mittel umfassen:

Zweite Multiplexiermittel (22) mit einer Mehrzahl von Eingangsknoten und

wobei die N Verzögerungselemente eine zweite Übertragungsleitung (23) umfassen mit einer Mehrzahl von Anzapfungen an Intervallen derselben, wobei jede Anzapfung an einen aufeinanderfolgenden Eingangsknoten der zweiten Multiplexiermittel angeschlossen ist.

4. Anordnung nach Anspruch 2 oder 3, dadurch gekennzeichnet, daß die ersten Multiplexiermittel (14, 16) adressierbare Steuerungen für selektives Anschließen einer der Anzapfungen auf der ersten Übertragungsleitung an den ersten Knoten umfassen.

5. Anordnung nach Anspruch 4, dadurch gekennzeichnet, daß die ersten Multiplexiermittel (14, 16) einen ersten Multiplexer (14, 16) umfassen mit Differenzialeingangsstufen und daß die erste Übertragungsleitung (15, 17) eine Differenzialübertragungsleitung umfaßt, angeschlossen an die Differenzialeingangsstufen.

6. Anordnung nach Anspruch 5, dadurch gekennzeichnet, daß Abschlußmittel (13, 18) vorgesehen sind, die auf eine letzte Eingangsklemme des ersten Multiplexers (14, 16) folgen zum Abschließen der ersten Übertragungsleitung.

7. Anordnung nach einem der Ansprüche 3 bis 6, dadurch gekennzeichnet, daß die zweiten Multiplexiermittel (22) adressierbare Steuerungen umfassen für selektives Anschließen einer der Anzapfungen auf der zweiten Übertragungsleitung an die Ausgangsklemme.

8. Anordnung nach einem der Ansprüche 1 bis 7, gekennzeichnet durch

einen Satz von M Verzögerungselementen (21), worin M eine ganze Zahl ist, wobei jedes Element ein drittes nominell vorbestimmtes Verzögerungsintervall bestimmt, welches dritte nominell vorbestimmte Verzögerungsintervall größer ist als das zweite nominell vorbestimmte Verzögerungsintervall, dividiert durch M und

dritte Mittel (20), angeschlossen zwischen der Ausgangsklemme und den zweiten Verzögerungsmitteln zum Empfang des zweiten verzögerten Signals von den zweiten Mitteln und angeschlossen an die M Verzögerungselemente, wobei die dritten Mittel betätigbar sind zum Durchschleusen des zweiten verzögerten Signals durch eine ausgewählte Serie der M Verzögerungselemente und dessen Verzögerung zum Bereitstellen eines dritten verzögerten Signals an der Ausgangsklemme.

9. Anordnung nach Anspruch 8, dadurch gekennzeichnet, daß die dritten Mittel dritte Multiplexiermittel (20) umfassen mit einer Mehrzahl von Eingangsklemmen und mindestens einer dritten Ausgangsklemme und

daß der Satz von M Verzögerungselementen eine dritte Übertragungsleitung (21) umfaßt mit einer Mehrzahl von Anzapfungen an Intervallen, angeschlossen an aufeinanderfolgende Eingangsklemmen des dritten Multiplexers.

**Revendications**

1. Dispositif connecté entre une borne d'entrée et une borne de sortie pour retarder un signal électrique appliqué à la borne d'entrée avant de l'appliquer à la borne de sortie, le dispositif comprenant:

des premiers moyens (14, 15; 16, 17) pour retarder des signaux d'un multiple sélectionné d'un premier intervalle de retard nominalement prédéterminé, les premiers moyens étant connectés à la borne d'entrée pour recevoir le signal électrique et le retarder en le faisant passer dans une ligne à retard pour fournir un premier signal retardé à un premier noeud; caractérisé par:

N éléments à retard (23), N étant un entier supérieur à un, chaque élément fournissant un deuxième intervalle de retard nominalement prédéterminé supérieur au premier intervalle de retard nominalement prédéterminé divisé par N, les N éléments à retard formant une deuxième ligne à retard ayant une pluralité de bornes disposées à intervalles;

des deuxièmes moyens (22) connectés au premier noeud pour recevoir le premier signal retardé, connectés à la borne de sortie et connectés aux N éléments à retard, les deuxièmes moyens étant adaptés à faire passer le premier signal retardé au travers d'une série sélectionnée des N éléments à retard pour retarder encore le premier signal retardé et fournir un deuxième signal retardé à la borne de sortie.

2. Dispositif selon la revendication 1, caractérisé en ce que les premiers moyens (14, 15; 16, 17) comprennent:

des premiers moyens de multiplexage (14; 16) ayant une pluralité de bornes d'entrée; et

une première ligne de transmission (15; 17) ayant une pluralité de bornes de liaison disposées à intervalles, chaque borne de liaison étant connectée à une borne d'entrée successive des premiers moyens de multiplexage.

3. Dispositif selon la revendication 1 ou 2, caractérisé en ce que les deuxièmes moyens comprennent:

des deuxièmes moyens de multiplexage (22) ayant une pluralité de noeuds d'entrée; et

dans lequel les N éléments à retard comprennent une deuxième ligne de transmission (23) ayant la pluralité de bornes de liaison disposées à intervalles, chaque borne étant connectée à un noeud d'entrée successif des deuxièmes moyens de multiplexage.

4. Dispositif selon la revendication 2 ou 3, caractérisé en ce que les premiers moyens de multiplexage (14; 16) comprennent des commandes d'adresses pour connecter sélectivement l'une des bornes de liaison de la première ligne de transmission au premier noeud.

5. Dispositif selon la revendication 4, caractérisé en ce que les premiers moyens de multiplexage (14; 16) comprennent un premier multiplexeur (14; 16) incluant des étages d'entrée différentiels et la première ligne de transmission (15; 17) comprend une ligne de transmission différentielle connectée aux étages d'entrée différentiels.

6. Dispositif selon la revendication 5, caractérisé en ce que des moyens de terminaison (13; 18) sont prévus après une dernière borne d'entrée du premier multiplexeur (14; 16) pour terminer la première ligne de transmission (15; 17).

7. Dispositif selon l'une des revendications 3 à 6, caractérisé en ce que les deuxièmes moyens de multiplexage (22) comprennent des commandes d'adresses pour connecter sélectivement l'une des bornes de liaison de la deuxième ligne de transmission à la borne de sortie.

8. Dispositif selon l'une des revendications 1 à 7, caractérisé par:

un ensemble de M éléments à retard (21), M étant un entier, chaque élément fournissant un troisième intervalle de retard nominalement prédéterminé, ce troisième intervalle de retard nominalement prédéterminé étant supérieur au deuxième intervalle de retard nominalement prédéterminé divisé par M; et

des troisièmes moyens (20) connectés entre la borne de sortie et els deuxièmes moyens pour recevoir le deuxième signal retardé des deuxièmes moyens, et connectés aux M éléments à retard, les troisième moyens étant adaptés à faire passer le deuxième signal retardé au travers d'une série sélectionnée des M éléments à retard et à le retarder pour fournir un troisième signal retardé à la borne de sortie.

9. Dispositif selon la revendication 8, caractérisé en ce que:

les troisièmes moyens comprennent des troisièmes moyens de multiplexage (20) ayant une pluralité de bornes d'entrée et au moins une troisième borne de sortie, et

l'ensemble de M éléments à retard comprend une troisième ligne de transmission (21) ayant une pluralité de bornes de liaison disposées à intervalles et connectées aux bornes d'entrée successives des troisièmes moyens de multiplexage.

FIG._1.

FIG._2.

FIG.—3.

FIG.__4.

FIG._5.

FIG._6.